# EUROPEAN PATENT SPECIFICATION

(11) **EP 2 010 927 B1**
(45) Date of publication and mention of the grant of the patent: **09.03.2011**
(21) Application number: 07760604.4
(22) Date of filing: 12.04.2007
(51) Int. Cl.: G01R 31/3185

(54) **TEST ACCESS PORT SWITCH**
TESTZUGANGSPORTSCHALTER
COMMUTATEUR DE PORT D'ACCES DE TEST

(30) Priority: 12.04.2006 US 402431
(43) Date of publication of application: 07.01.2009
(73) Proprietor: QUALCOMM Incorporated, San Diego, California 92121 (US)
(72) Inventor: BURKE, Kevin Charles, Raleigh, NC 27613 (US); POTTIER, Philip Richard, San Diego, CA 92117 (US); VARADARAJAN, Srinivas, San Diego, CA 92131 (US)
(74) Representative: Hess, Peter K. G.
(86) International application number: PCT/US2007/066577
(87) International publication number: WO 2007/121330

(56) References cited:
- EP-A- 1 544 633
- US-A1- 2005 257 108
- US-B1- 6 324 662

## Description

### FIELD

The present disclosure generally relates to testing of electronic circuit components, and particularly relates to accessing and testing multiple electronic components in a system.

### BACKGROUND

Common modem electronic systems comprise a plurality of electronic components, each component enabling a particular function or set of functions within a system. For example, conventional computer systems may comprise one or more electronic components such as microprocessors, Digital Signal Processors (DSPs), memory devices, graphics devices, input/output devices, physical access devices (PHYs), controllers and the like. Other systems may require additional or different components. For example, a wireless communication system may comprise analog-to-digital and digital-to-analog components as well as baseband and other signal processing components.

It is desirable that each electronic component contained in a modem electronic system be testable. Accordingly, each electronic component should be accessible, excitable and observable within a system. Isolating and testing components within a system presents unique and difficult challenges given the ever-evolving complexity, and increasing levels of integration of modem circuit design. Advancements in semiconductor processing technology further compound, these challenges, e.g., by allowing more transistors to be fabricated in smaller areas with increased performance and new functionality. Advancements in semiconductor processing technology have also enabled the integration of various semiconductor technologies on a single die or chip. For example, CMOS, bi-CMOS and/or bi-polar devices can be fabricated on the same die to produce Integrated Circuits (ICs) having mixed-signal capability.

The complexities associated with testing modem ICs are further increased when various electronic components are incorporated in a system. The ability to access and test a single component within a system is complex. One solution that has eased some of the complications associated with isolating and testing individual components included in a system is IEEE's boundary scan methodology (IEEE 1149.1). IEEE 1149.1 provides a methodology by which various electronic components integrated in a system can be interconnected via a serial boundary scan path. Information can be scanned into and out of components coupled to the boundary scan path. The IEEE 1149.1 standard reduces the number of signal I/Os needed for accessing, exciting and observing a particular component within a system.

In one example, the IEEE 1149.1 boundary scan methodology can be integrated into a wireless communication device for testing electronic components included in the wireless system such as a DSP. The DSP can be isolated from other system components and tested using the IEEE 1149.1 boundary scan methodology. The position of each component within the boundary scan path in addition to the length of each boundary scan instruction and data registers are needed to successfully access the DSP. As such, the exemplary DSP can be isolated and tested by shifting information through the other components until the information reaches the DSP. Results can be subsequently scanned out in a similar fashion. As a result, electronic components included in a system can be accessed and tested via a reduced-pin boundary scan test interface.

However, the serial scan path architecture associated with conventional boundary scan methodologies presents unique problems in low power applications, e.g., portable computing and wireless communication applications. In low power systems, power to one or more components forming part of a boundary scan path may be cycled off when not in use, thereby extending battery life of the system. However, when a component forming part of a boundary scan path is powered off, other components in the path cannot be reliably accessed because the serial scan path is disrupted or broken when a component in the path is not powered on. Conventional low-power systems that routinely cycle component power on and off can render the use of a serial boundary scan architecture for isolating and accessing a particular component sporadic at best.
Publication US-B-6,324,662 referring to testing integrated circuits with multiple cores is one such example exhibiting these power cycling problems.

Further, the serial scan path associated with conventional boundary scan architectures reduces test performance in that information must be loaded into and out of the boundary scan path serially through each component forming the scan path. Components in the scan path that are not being accessed may be bypassed, which conventionally involves selecting a one-bit bypass register in each non-active component so that serial information can be scanned through the boundary scan path via the one-bit bypass registers until it reaches the desired component. However, as the number of electronic components included in modern electronic systems increases, the efficiency associated with bypassing each component not under test can adversely impact performance. In addition, the number of bits required for instruction register scan operations corresponds to the total bit length of all instruction registers included in the system, thus further increasing test time as the number of components included in a system increases.

### SUMMARY OF THE DISCLOSURE

According to the methods and apparatus taught herein, a Test Access Port (TAP) switch provides a centralized serial test interface between an electronic system and a resource external to the electronic system. The electronic system in which the TAP switch is included comprises a plurality of electronic circuit components, each electronic circuit component having a TAP coupled to the TAP switch. The centralized architecture of the TAP switch enables the switch to receive serialized information from the external source, e.g., a test system, and to forward the information to a selected one of the TAPs included in the electronic system regardless of whether the non-selected TAPs are powered on or off. In one or more embodiments, the TAP switch comprises a first circuit configured to provide a clock signal to a selected one of the TAPs responsive to a selection code included in a serialized instruction. The TAP switch further comprises a second circuit comprising an instruction register (IR) configured to pass serialized instructions received by the TAP switch to the selected TAP and a third circuit configured to forward serialized data received from the selected TAP to an output of the TAP switch responsive to the selection code.

Thus, in at least one embodiment, the TAP switch controls access to the TAPs by providing a clock signal to a selected one of the TAPs responsive to the selection code, passes serialized instructions received by the TAP switch to the selected TAP and forwards serialized data received from the selected TAP to an output of the TAP switch responsive to the selection code. The TAP switch is further capable of selecting a different TAP by providing the clock signal to a newly selected one of the TAPs in response to a change in the selection code, thus enabling multiple TAPs to be selected during a single debug session.

Only minimal modifications to conventional boundary scan debugger programs are commonly used to make the TAP switch backward compatible with conventional programs. In one embodiment, a computer program product for controlling access to two or more TAPs in an electronic system comprises program code for causing the TAP switch to select one of the TAPs responsive to a selection code included in a serialized instruction and program code for including the selection code in subsequent instruction register-related instructions. The computer program product may further comprise program code for maintaining the TAP switch in an idle state for at least two test clock cycles after the selection code is scanned into the TAP switch.

Of course, the present disclosure is not limited to the above features. Those skilled in the art will recognize additional features upon reading the following detailed description, and upon viewing the accompanying drawings.

### BRIEF DESCRIPTION OF DRAWINGS

Fig. 1 is a block diagram illustrating an embodiment of an electronic system including a Test Access Port (TAP) switch coupled to a plurality of integrated circuits.

Fig. 2 is a logic flow diagram illustrating an embodiment of program logic for accessing one of two or more TAPs included in the electronic system of Fig. 1.

Fig. 3 is a block diagram illustrating an embodiment of the TAP switch included in the electronic system of Fig. 1.

Fig. 4 is a state transition diagram illustrating one embodiment of state machine logic associated with the TAP switch of Fig. 3.

Fig. 5 is a logic flow diagram illustrating an embodiment of program logic for controlling access to two or more TAPs by the TAP switch of Fig 3.

### DETAILED DESCRIPTION

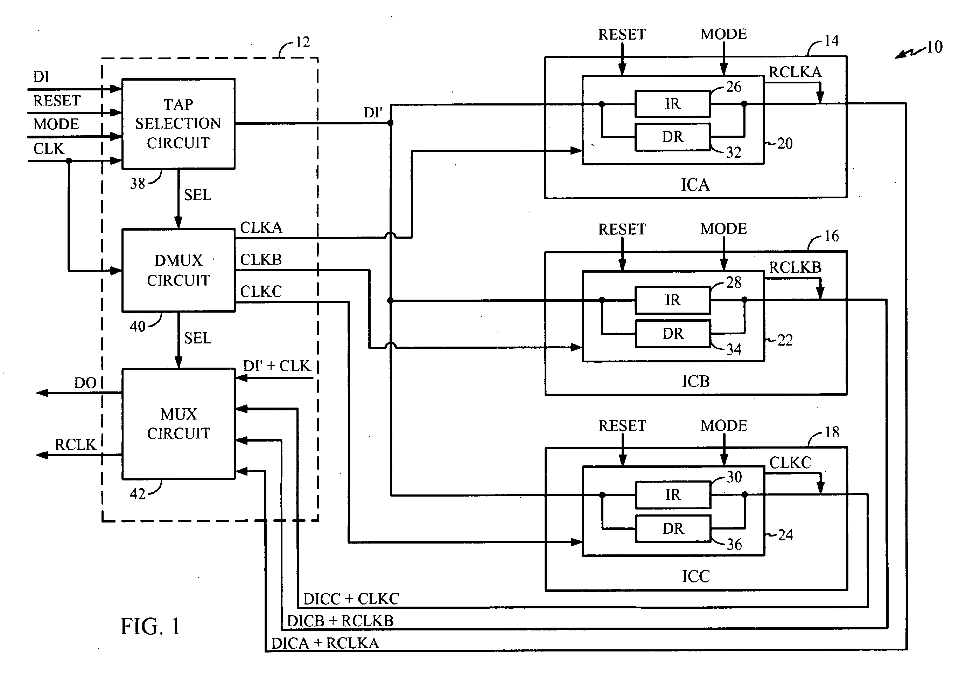

Figure 1 illustrates an embodiment of an electronic system 10 including a Test Access Port (TAP) switch 12 and a plurality of testable electronic circuit components such as integrated circuits (ICs) 14-18. Each system IC 14-18 has a TAP 20-24 for facilitating communication with the TAP switch 12. Particularly, each TAP 20-24 includes an Instruction Register (IR) 26-30 for capturing serialized instructions and a Data Register (DR) 32-36 for capturing serialized test data. The TAP switch 12 in turn provides a centralized serial test interface between the electronic system 10 and a resource external to the electronic system (not shown), e.g., a test or debug system directly or remotely coupled to the electronic system 10. The TAP switch 12 is the first device located in a boundary scan path included in or associated with the electronic system 10. The centralized architecture of the TAP switch 12 enables the switch 12 to receive test instructions, data and control information from an external source and to forward the information to a selected one of the IC TAPs 20-24 regardless of whether the non-selected ICs are powered on or off. As such, the TAP switch 12 is well suited for inclusion in systems adapted for low power applications such as portable computing and wireless communication systems.

Each system IC 14-18 enables a particular function or set of functions associated with the system 10. For example, the ICs 14-18 may comprise one or more microprocessors, Digital Signal Processors (DSPs), memory devices, graphics devices, input/output devices, physical access devices (PHYs), controllers, analog-to-digital and digital-to-analog components, baseband and other signal processing components, and the like. The electronic system 10 is particularly adapted for low power applications such as mobile computing and wireless communication applications and can take form in one of several configurations. For example, the electronic system 10 may be formed by interconnecting the ICs 14-18 on a carrier such as a board or multi-chip module (MCM) or within a System-on-Chip (SoC) design, or some combination thereof. The ICs 14-18 may comprise separate chips to be mounted on a board, separate die to be mounted on an MCM, or separate cores within a SoC, or some combination thereof. Regardless of the particular functions supported by the ICs 14-18 and the application in which the electronic system 10 is utilized, a boundary scan path is used to facilitate communication with the ICs 14-18 after they have been interconnected within the system 10. Because the boundary scan interface between the TAP switch 12 and each of the system ICs 14-18 is a parallel one, a particular IC can be accessed, excited and observed regardless of the power-on status of the other ICs included in the system 10. That is, the TAP switch 12 can communicate with a selected one of the IC TAPs 20-24 regardless of the powered status of the other IC TAPs. Thus, disruptions in the use of a conventional 'daisy-chain' boundary scan configuration due to component power cycling are eliminated by using the TAP switch 12 as a centralized hub for accessing and communicating with selected components included in the system 10.

To facilitate selective communication with the IC TAPs 20-24, one embodiment of the TAP switch 12 comprises a selection circuit 38, a demultiplexer circuit 40 and a multiplexer circuit 42. The TAP switch 12 functions as a test interface for the electronic system 10 by receiving serial test information (DI), a mode select signal (MODE) and a test clock signal (CLK) from an external resource. Optionally, the TAP switch 12 may receive a test reset signal (RESET) that provides for an asynchronous reset of the switch 12. Further, the TAP switch 12 outputs serial test data (DO) received from a selected one of the IC TAPs 20-24 and an optional return clock signal (RCLK) used to synchronize one or more of the ICs 14-18 with a system clock during testing.

In response to an instruction received by the TAP switch 12 that indicates which IC TAP is to be selected, i.e., a select TAP instruction, the selection circuit 38 captures a selection code included in the select TAP instruction, e.g., a code appended or prepended to the instruction. The selection circuit 38 then stores the selection code and provides it to the demultiplexer and multiplexer circuits 40, 42 (SEL). The selection code causes the demultiplexer circuit 40 to provide a clock signal to a particular one of the IC TAPs 20-24, thus selecting that TAP. That is, the selection code uniquely identifies each testable IC 14-18 included in the system 10. In response to this unique code, the demultiplexer circuit 40 selects only one IC TAP to receive a test clock signal. For example, the demultiplexer circuit 40 provides a test clock signal (CLKA) to ICA 14 in response to a TAP select instruction having a selection code associated with ICA 14 included therein. The TAPs that do not receive an active test clock signal from the TAP switch 12 remain idle while the selected TAP is accessed (in this example, TAPs 22 and 24 of ICB 16 and ICC 18, respectively, are not clocked). The selection code also causes the multiplexer circuit 42 to forward an unaltered version of serialized data received from the selected TAP to the DO output of the TAP switch 12. Because each testable IC 14-18 is coupled to the TAP switch 12 in parallel, the TAP switch 12 allows an external test system to dynamically select and independently communicate with individual TAPs regardless of the power-on status of the other ICs included in the system 10.

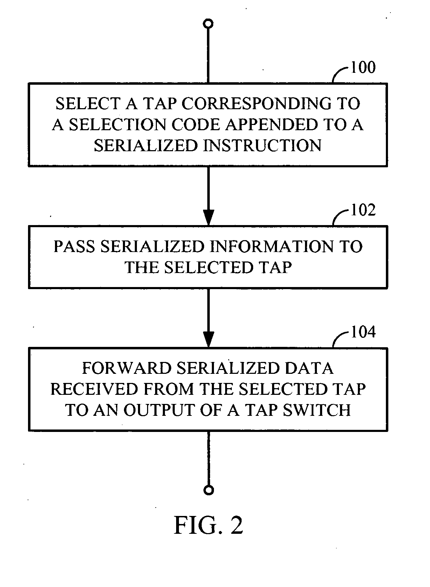

Figure 2 illustrates one embodiment of program logic for accessing an IC TAP by the TAP switch 12. The program logic "begins" with the TAP switch 12 selecting the IC TAP that corresponds to the selection code (Step 100). The selection code is included in a serialized instruction received by the TAP switch 12 such as a select TAP instruction. The TAP switch 12 provides the selection code to the demultiplexer circuit 40 which in turn provides an active test clock to the corresponding IC TAP, thus selecting the TAP. After the proper IC TAP has been selected, the TAP switch 12 then passes serialized information received by the switch 12 from an external source to the selected TAP (Step 102). The serialized information may comprise instructions, data or control information. Serialized data received by the TAP switch 12 from the selected IC TAP (DICA, DICB, or DICC) is forwarded unaltered by the multiplexer circuit 42 to the DO output of the switch 12 (Step 104). Optionally, a test clock signal output by the selected TAP (RCLKA, RCLKB, or CLKC) may also be received by the TAP switch. As such, information received from the selected IC TAP is provided by the TAP switch 12 to an external system for analysis. The program logic illustrated in Figure 2 is executed each time a change occurs to the selection code, thus indicating a different IC TAP is to be accessed.

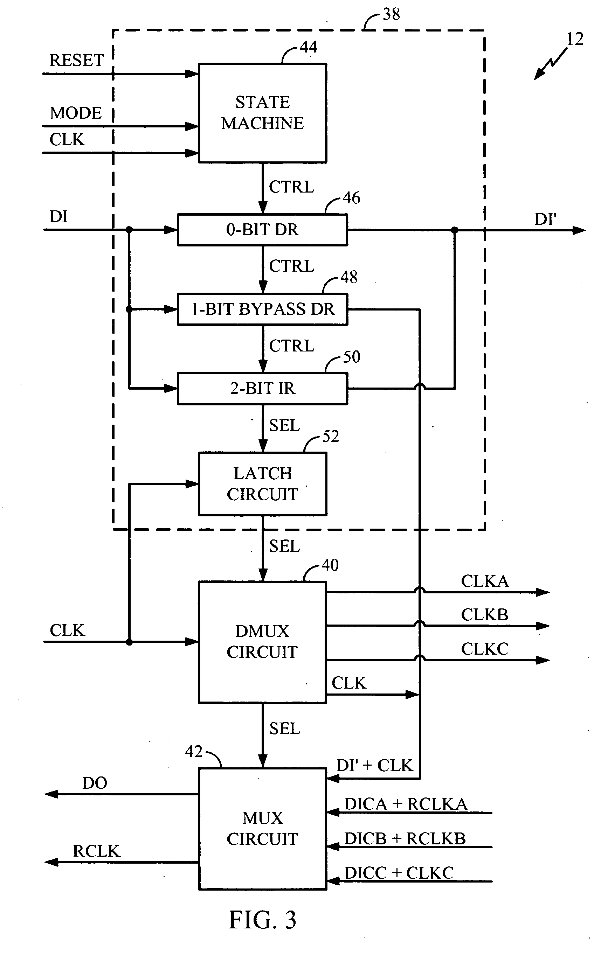

Figure 3 illustrates an embodiment of the TAP switch 12. The test interface of the TAP switch 12 is fully compliant with the IEEE 1149.1 boundary scan standard. Because the TAP switch 12 is fully compliant with the IEEE 1149.1, serialized test information received by the switch 12 from an external source is simply passed to a selected one of the IC TAPs 20-24 without requiring any decoding or manipulation thereof by the switch 12. As such, IEEE 1149.1 compliant operations are fully supported by the TAP switch 12. The selection circuit 38 of the TAP switch 12 comprises a state machine 44, a zero-bit Data Register (DR) 46, a one-bit bypass DR 48, a two-bit IR 50 and a latch circuit 52. The state machine 44 controls which register is selected for receiving serialized information from the DI input of the TAP switch 12 (CTRL). The zero-bit DR 46 is selected in response to the state machine 44 detecting a data scan instruction, e.g., an IEEE 1149.1 compliant Select-DR, Capture-DR, Shift-DR, Exit-DR, Pause-DR, or Update-DR operation. By utilizing a zero-bit pass-through path for data scan operations, serialized information can be passed from the DI input of the TAP switch 12 to a selected TAP (not shown) via the zero-bit DR 46 without having to account for one or more bypass bits associated with conventional TAP controllers, thus improving performance.

The one-bit bypass DR 48 is selected in response to the state machine 44 detecting a bypass instruction. In response to a bypass instruction, serialized information received by the TAP switch 12 is diverted from the DI input to the DO output of the switch 12 via the multiplexer circuit 42. As such, the selected TAP does not receive any serialized information when the TAP switch 12 is in bypass mode. In one example, the selection code is set to all logic ones to indicate a bypass operation, e.g., '11' in the present system illustration. When the '11' selection code is provided to the multiplexer circuit 42, the circuit 42 couples the output of the one-bit bypass DR 48 to the DO output of the TAP switch 12, thus circumventing the selected TAP.

The two-bit IR 50 is selected in response to the state machine 44 detecting an instruction register instruction, e.g., IEEE 1149.1 compliant Select-IR, Capture-IR, Shift-IR, Exit-IR, Pause-IR, or Update-IR operation. In the present system illustration, the TAP switch IR 50 has a width of two bits. The two-bit IR 50 holds the selection code which is included in IR instructions. Generally, the bit width of the TAP switch IR 50 is a function of the number of testable ICs accessed by the TAP switch 12. For example, if the TAP switch IR 50 were three bits in width, up to seven IC TAPs could be uniquely identified and accessed by the TAP switch 12 while leaving one selection code state for indicating the bypass mode. The latch circuit 52 stores selection code values loaded into the two-bit ISR 50 and provides the selection codes (SEL) to the demultiplexer and multiplexer circuits 40, 42. In one embodiment, the latch circuit 52 comprises a register coupled to latch devices (not shown).

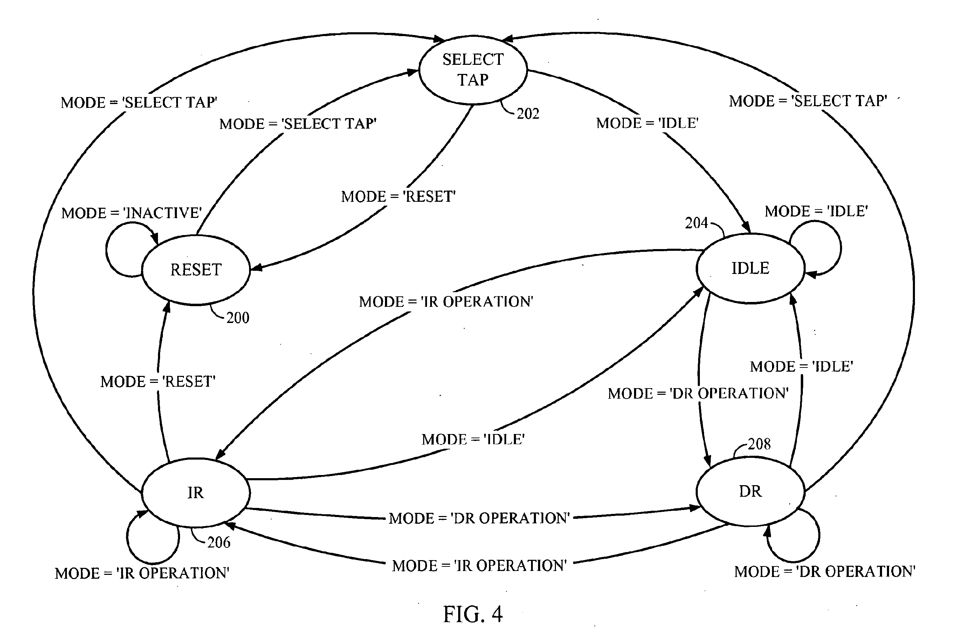

The state machine 44 causes the TAP switch 12 to transition from state-to-state in response to the current state of the switch 12, the mode select signal (MODE) and transitions in the test clock signal (CLK). Figure 4 illustrates an embodiment of state transition logic associated with the TAP switch state machine 44. Upon power-up or reset of the TAP switch 12, the state machine 44 enters a reset state 200, e.g., the IEEE 1149.1 Test-Logic-Reset state. The TAP switch 12 remains in the reset state 200 so long as the mode signal remains inactive. The state machine 44 transitions to a select TAP state 202 when the TAP switch 12 exits the reset state 200 in response to a change in the mode signal. While in the select TAP state 202, the TAP switch 12 selects a particular TAP to access in response to the selection code scanned into the TAP switch IR 50 as previously described. The state machine 44 then transitions to an idle state 204, e.g., the IEEE 1149.1 Run Test/Idle state. The state machine 44 remains in the idle state 204 so long as the mode signal indicates that the TAP switch 12 is to remain idle. Minimally, the state machine 44 maintains the TAP switch 12 in the idle state 204 for a sufficient number of test clock cycles to enable the switch 12 to store the selection code and to ensure that the newly selected TAP (TAP 20, 22, or 24) will be placed in the Run Test/Idle state in the event that it had entered a Test-Logic-Reset state as a result of power cycling.

In response to the mode signal indicating an IR instruction, the state machine enters an IR state 206. For example, an IEEE 1149.1 Select-IR scan operation causes the state machine 44 to transition to the IR state 206. The state machine 44 causes the TAP switch 12 to remain in the IR state 206 so long as the mode signal indicates that IR instructions are being performed, e.g., IEEE 1149.1 Capture-IR, Shift-IR, Exit-IR, Pause-IR, or Update-IR operations. A subsequent select TAP instruction causes the state machine 44 to transition back to the select TAP state 202 while a reset causes a transition back to the reset state 200.

In response to the mode signal indicating a DR instruction, the state machine 44 transitions to a DR state 208. For example, an IEEE 1149.1 Select-DR scan operation causes the state machine 44 to transition to the DR state 208. The state machine 44 causes the TAP switch 12 to remain in the DR state 208 so long as the mode signal indicates that DR instructions are being performed, e.g., IEEE 1149.1 Capture-DR, Shift-DR, Exit-DR, Pause-DR, or Update-DR operations. A subsequent select TAP instruction causes the state machine 44 to return to the select TAP state 202 while a reset causes a transition back to the reset state 200. An idle instruction causes the state machine 44 to transition from either the IR or DR states 206, 208 to the idle state 204.

Regardless of the present state of the TAP switch 12, the state machine 44 causes the switch 12 to enter the select TAP state 202 when a select TAP instruction is recognized by the switch 12. As such, the TAP switch 12 is capable of selecting a different TAP in response to a change in the selection code, thus enabling the switch 12 to access multiple TAPs during a single debug session. As a result, debug performance is improved and complexity is reduced.

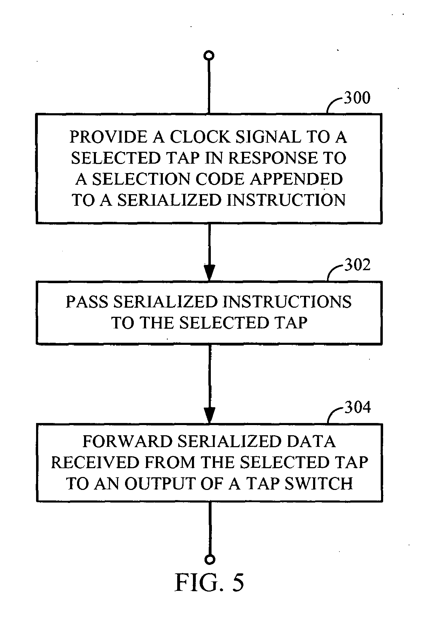

Figure 5 illustrates one embodiment of program logic for controlling access to the IC TAPs 20-24 by the TAP switch 12. The program logic "begins" with the TAP switch 12 providing a clock signal to a selected one of the TAPs 20-24 in response to the selection code (Step 300). In the present example, a select TAP instruction having a selection code of '01' included therein causes the TAP switch 12 to select TAP 22 of ICB 16 by providing a test clock signal (CLKB) only to TAP 22. The IR 50 of the TAP switch 12 passes serialized instructions received by the TAP switch 12 to the selected TAP (Step 302). Because the multiplexer circuit 42 previously configured the TAP switch 12 to receive data from the selected TAP in response to the stored selection code, serialized data subsequently received by the TAP switch 12 from the selected TAP is forwarded unaltered to the DO output of the switch 12 (Step 304). As such, serial data received from the selected IC TAP can be provided by the TAP switch 12 to an external system as part of testing. A new IC TAP is selected each time the TAP switch 12 recognizes a select TAP instruction, thus enabling the switch 12 to select multiple IC TAPs during a single debug session.

Only minimal modifications to preexisting debugger software programs are commonly used to make the TAP switch 12 backward compatible with preexisting programs. Conventional boundary scan debugger programs enable remote control of a system via one or more TAP interfaces. For example, conventional debugger programs enable downloading of programs to memory, starting and stopping execution of debug programs, setting of debug breakpoints and watchpoints, analyzing contents of registers and memory, and collecting real-time execution data.

A first modification to a conventional debugger program involves adding support for the select TAP instruction. The select TAP instruction is issued each time the TAP switch 12 transitions out of the reset state 200 or when a different IC TAP is selected for access during a debug session. To support the select TAP instruction, the debugger program is made aware of three variables: the bit length of the longest TAP IR included in the system, the bit length of the TAP switch IR 50, and the unique selection codes associated with each IC TAP 20-24 included in the system 10.

The debugger program processes the IR bit length information provided to the program to generate a select TAP instruction for initializing the TAP switch 12, thus causing the switch 12 to select one of the TAPs 20-24. The length of the longest TAP IR is used by the debugger program to ensure that all of the TAP IRs 20-24 included in the system 10 are loaded with a bypass code during a select TAP instruction sequence, thereby ensuring that no IC TAP performs an undesirable operation when the TAP switch 12 is selecting one of the TAPs 20-24. For illustrative purposes only, the TAP IR 26 associated with ICA 14 is four bits wide, the TAP IR 28 associated with ICB 16 is five bits wide and the TAP IR 30 associated with ICC 18 is four bits wide. As such, the longest TAP IR, that is the TAP IR 28 included in ICB 16, is always loaded with a bypass instruction during the select TAP instruction sequence.

The bit length of the TAP switch IR 50 is provided to the debugger program so that a selection code having a correct length is loaded into the TAP switch IR 50 during a select TAP operation. Finally, the unique selection code associated with each IC TAP 20-24 is provided to the debugger program so that the TAPs 20-24 can be uniquely identified by the TAP switch 12. As such, a select TAP instruction comprises the selection code included in a bypass instruction, e.g., <xxyyyyy> where xx = the selection code associated with the TAP to be selected and yyyyy = the bit sequence associated with a bypass instruction. In one example, xx = '10' and yyyyy = '11111' where '10' indicates the TAP 24 associated with ICC 18 and '11111' indicates the bypass instruction. Those skilled in the art will recognize that one or more leading logic one values will be dropped from those TAP IRs having a bit length shorter than the longest TAP IR included in the system, e.g., the TAP IRs 26, 30 associated with ICA 14 and ICC 18 in the present system 10. However, by ensuring that the bypass instruction has a bit width equal to the length of the longest TAP IR, all the TAP IRs 20-24 will be loaded with the bypass instruction. Thus, undesirable TAP operations are prevented in all of the IC TAPs 20-24 when the select TAP sequence is being executed by the TAP switch 12.

A second modification to a conventional debugger program involves maintaining the TAP switch 12 in the idle state 204 for a sufficient number of test clock cycles after the selection code is loaded into the TAP switch IR 50 during a select TAP instruction sequence. This provides the TAP switch 12 sufficient time to properly store the selection code in its latch circuit 52. For example, the TAP switch 12 is maintained in the IEEE 1149.1 compliant Run Test/Idle state for at least two clock cycles after the switch 12 recognizes a select TAP instruction. Maintaining the TAP switch 12 in the Run Test/Idle state also ensures that the newly selected TAP will be placed in the Run Test/Idle state in the event that it had previously entered a Test-Logic-Reset state as a result of power cycling.

A third modification to a conventional debugger program involves including the selection code in IR instructions issued subsequent to a select TAP instruction, thus accounting for the TAP switch IR 50 during IR operations. For example, the debugger is modified to append or prepend the selection code to IR instructions. Further, unlike the select TAP instruction which must account for the longest TAP IR included in the system 10, all subsequent IR instructions need only account for the length of the TAP IR associated with the presently selected TAP. As such, the architecture of the TAP switch 12 improves performance in that all subsequent IR instructions have a length equal to the bit length of the presently selected TAP IR plus the bit length of the TAP switch IR 50. Unlike conventional daisy-chain boundary scan configurations, the total length of all TAP IRs 26-30 included in the system 10 need not be accounted for during subsequent IR instructions.

With the above range of variations and applications in mind, it should be understood that the present disclosure is not limited by the foregoing description, nor is it limited by the accompanying drawings. Instead, the present disclosure is limited only by the following claims.

IN THE FOLLOWING, FURTHER EMBODIMENTS ARE DESCRIBED TO FACILITATE UNDERSTANDING:
1. A test access port (TAP) switch for providing access to two or more TAPs, the TAP switch comprising:
   a first circuit configured to provide a clock signal to a selected one of the TAPs responsive to a selection code included in a serialized instruction received by the TAP switch;
   a second circuit comprising an instruction register (IR) configured to pass serialized instructions received by the TAP switch to the selected TAP; and
   a third circuit configured to forward serialized data received from the selected TAP to an output of the TAP switch responsive to the selection code.
2. The TAP switch of number 1, wherein the IR is configured to capture the selection code responsive to a select TAP instruction.
3. The TAP switch of number 2, wherein the second circuit further comprises a latch circuit configured to store the selection code captured by the IR and to provide the selection code to the first and third circuits.
4. The TAP switch of number 1, wherein the second circuit further comprises a zero-bit data register (DR) configured to pass serialized data received by the TAP switch to the selected TAP responsive to a data scan instruction.
5. The TAP switch of number 4, wherein the second circuit further comprises a bypass DR configured to divert the serialized data received by the TAP switch to the output of the TAP switch responsive to a bypass instruction.
6. The TAP switch of number 5, wherein the bypass instruction corresponds to the selection code indicating a TAP switch bypass state.
7. The TAP switch of number 6, wherein the third circuit is configured to forward the diverted serialized data from the bypass DR to the output of the TAP switch responsive to the selection code indicating the TAP switch bypass state.
8. The TAP switch of number 5, wherein the second circuit further comprises state machine logic configured to select the IR responsive to an IR instruction, to select the zero-bit DR responsive to the data scan instruction and to select the bypass DR responsive to the bypass instruction.
9. The TAP switch of number 1, wherein the first circuit is configured to provide the clock signal to a newly selected one of the TAPs responsive to a change in the selection code, the IR is configured to pass serialized instructions subsequently received by the TAP switch to the newly selected TAP, and the third circuit is configured to forward serialized data subsequently received from the newly selected TAP to the output of the TAP switch responsive to the changed selection code.
10. The TAP switch of number 1, wherein the first circuit comprises a demultiplexer circuit and the third circuit comprises a multiplexer circuit.
11. An electronic system, comprising:
   a plurality of electronic circuit components, each electronic circuit component having a test access port (TAP); and
   a TAP switch for providing access to each TAP, the TAP switch comprising:
      a first circuit configured to provide a clock signal to a selected one of the TAPs responsive to a selection code included in a serialized instruction received by the TAP switch;
      a second circuit comprising an instruction register (IR) configured to pass serialized instructions received by the TAP switch to the selected TAP; and
      a third circuit configured to forward serialized data received from the selected TAP to an output of the TAP switch responsive to the selection code.
12. The electronic system of number 11, wherein each electronic circuit component comprises a core associated with a system-on-a-chip integrated circuit.
13. The electronic system of number 11, wherein each electronic circuit component comprises an integrated circuit mounted on a carrier.
14. The electronic system of number 11, wherein the second circuit further comprises a zero-bit data register (DR) configured to pass serialized data received by the TAP switch to the selected TAP responsive to a data scan instruction.
15. The electronic system of number 14, wherein the second circuit further comprises a bypass DR configured to circumvent the selected TAP by diverting the serialized data received by the TAP switch to the output of the TAP switch responsive to a bypass instruction.
16. The electronic system of number 15, wherein the third circuit is configured to forward the diverted serialized data from the bypass DR to the output of the TAP switch responsive to the bypass instruction.
17. The electronic system of number 15, wherein the second circuit further comprises state machine logic configured to select the TAP switch IR responsive to an IR instruction, to select the zero-bit DR responsive to the data scan instruction and to select the bypass DR responsive to the bypass instruction.
18. The electronic system of number 11, wherein the first circuit is configured to provide the clock signal to a newly selected one of the TAPs responsive to a change in the selection code, the TAP switch IR is configured to pass serialized instructions subsequently received by the TAP switch to the newly selected TAP, and the third circuit is configured to forward serialized data subsequently received from the newly selected TAP to the output of the TAP switch responsive to the changed selection code.
19. The electronic system of number 11, wherein the IR of the TAP switch is configured to capture the selection code responsive to a select TAP instruction.
20. The electronic system of number 19, wherein the select TAP instruction comprises the selection code included in a bypass instruction having a binary length of n, wherein n equals a bit length of a longest IR included in the TAPs.
21. The electronic system of number 19, wherein the second circuit further comprises a latch circuit configured to store the selection code captured by the TAP switch IR and to provide the selection code to the first and third circuits.
22. A method of controlling access to two or more test access ports (TAPs) by a TAP switch, comprising:
   providing a clock signal to a selected one of the TAPs responsive to a selection code included in a serialized instruction received by the TAP switch;
   passing serialized instructions received by the TAP switch to the selected TAP; and
   forwarding serialized data received from the selected TAP to an output of the TAP switch responsive to the selection code.
23. The method of number 22, further comprising storing the selection code in the TAP switch responsive to a select TAP instruction.
24. The method of number 22, further comprising passing serialized data received by the TAP switch to the selected TAP responsive to a data scan instruction.
25. The method of number 24, further comprising diverting the serialized data received by the TAP switch to the output of the TAP switch responsive to a bypass instruction.
26. The method of number 22, further comprising:
   providing the clock signal to a newly selected one of the TAPs responsive to a change in the selection code;
   passing serialized instructions subsequently received by the TAP switch to the newly selected TAP; and
   forwarding serialized data subsequently received from the newly selected TAP to the output of the TAP switch responsive to the changed selection code.
27. A method of accessing one of two or more test access ports (TAPs) in an electronic system, comprising:
   selecting one of the TAPs responsive to a selection code included in a serialized instruction received by a TAP switch;
   passing serialized information received by the TAP switch to the selected TAP; and
   forwarding serialized data received from the selected TAP to an output of the TAP switch.
28. The method of number 27, wherein selecting one of the TAPs comprises providing an active clock signal to a selected one of the TAPs responsive to the selection code.
29. The method of number 28, wherein providing an active clock signal to a selected one of the TAPs comprises:
   capturing the selection code in the TAP switch; and
   activating a clock signal output of the TAP switch corresponding to the TAP associated with the captured selection code.
30. The method of number 29, wherein capturing the selection code in the TAP switch comprises:
   scanning each bit of the select TAP instruction into the TAPs until the selection code is loaded into an instruction register (IR) of the TAP switch; and
   storing the selection code loaded in the TAP switch IR.
31. The method of number 30, wherein scanning each bit of the select TAP instruction into the TAPs until the selection code is loaded into the TAP switch IR comprises scanning n bits of the select TAP instruction into the TAPs, wherein n equals a bit length of a longest IR included in the TAPs.
32. The method of number 27, further comprising:
   newly selecting a different TAP responsive to a change in the selection code;
   passing serialized information subsequently received by the TAP switch to the newly selected TAP; and
   forwarding serialized data subsequently received from the newly selected TAP to the output of the TAP switch.
33. The method of number 27, further comprising bypassing the selected TAP responsive to a bypass instruction received by the TAP switch.
34. The method of number 33, wherein bypassing the selected TAP comprises diverting serialized data received by the TAP switch to the output of the TAP switch responsive to the bypass instruction.
35. The method of number 27, wherein passing serialized information received by the TAP switch to the selected TAP comprises:
   passing serialized data received by the TAP switch to the selected TAP via a zero-bit data register included in the TAP switch responsive to a data scan instruction; and
   passing serialized instructions received by the TAP switch to the selected TAP via an instruction register (IR) included in the TAP switch responsive to an IR instruction.
36. A computer program product for controlling access to two or more test access ports (TAPs) in an electronic system, comprising:
   program code for processing TAP instruction register bit length information; and
   program code for generating a serialized instruction including a selection code responsive to the TAP instruction register bit length information, the selection code configured to cause a TAP switch to select one of the TAPs.
37. The computer program product of number 36, further comprising program code for including the selection code in subsequently generated instruction register-related instructions.
38. The computer program product of number 36, further comprising program code for maintaining the TAP switch in an idle state for at least two test clock cycles after the selection code is scanned into the TAP switch.

## Claims

1. A test access port, TAP, switch for providing access to two or more TAPs, the TAP switch comprising:
a first circuit (40) configured to provide a clock signal to a selected one of the TAPs responsive to a selection code included in a serialized instruction received by the TAP switch;
a second circuit (38) comprising an instruction register (IR) configured to pass serialized instructions received by the TAP switch to the selected TAP; and
a third circuit (42) configured to forward serialized data received from the selected TAP to an output of the TAP switch responsive to the selection code;
**characterised in that**
the TAP switch is configured to maintain an idle state for a sufficient number of test clock cycles after the selection code included in the serialized instruction is received by the TAP switch, to ensure that the selected TAP will be placed in the idle state.

2. The TAP switch of claim 1, wherein the IR is configured to capture the selection code responsive to a select TAP instruction.

3. The TAP switch of claim 2, wherein the second circuit (38) further comprises a latch circuit (52) configured to store the selection code captured by the IR and to provide the selection code to the first and third circuits.

4. The TAP switch of claim 1, wherein the second circuit (38) further comprises a zero- bit data register DR (46) configured to pass serialized data received by the TAP switch to the selected TAP responsive to a data scan instruction.

5. The TAP switch of claim 4, wherein the second circuit (38) further comprises a bypass DR (48) configured to divert the serialized data received by the TAP switch to the output of the TAP switch responsive to a bypass instruction.

6. The TAP switch of claim 5, wherein the bypass instruction corresponds to the selection code indicating a TAP switch bypass state.

7. An electronic system (10), comprising:
a plurality of electronic circuit components (14-18), each electronic circuit component having a test access port TAP (20-24); and
a TAP switch (12) according to claims 1 to 4 for providing access to each TAP.

8. The electronic system of claim 7, wherein each electronic circuit component (14-18) comprises a core associated with a system-on-a-chip integrated circuit.

9. The electronic system of claim 7, wherein each electronic circuit component (14-18) comprises an integrated circuit mounted on a carrier.

10. A method of accessing one of two or more test access ports TAPs in an electronic system, comprising:
selecting (100) one of the TAPs responsive to a selection code included in a serialized instruction received by a TAP switch;
passing (102; 302) serialized information received by the TAP switch to the selected TAP; and
forwarding (104; 304) serialized data received from the selected TAP to an output of the TAP switch;
**characterised in that**
the TAP switch is configured to maintain an idle state for a sufficient number of test clock cycles after the selection code included in the serialized instruction is received by the TAP switch, to ensure that the selected TAP will be placed in the idle state.

11. The method of claim 10, wherein selecting (100) one of the TAPs comprises providing an active clock signal to a selected one of the TAPs responsive to the selection code.

12. The method of claim 11, wherein providing an active clock signal to a selected one of the TAPs comprises:
capturing the selection code in the TAP switch; and
activating a clock signal output of the TAP switch corresponding to the TAP associated with the captured selection code.

13. A computer program product for controlling access to two or more test access ports (TAPs) in an electronic system, comprising:
program code for processing TAP instruction register bit length information; and
program code for generating a serialized instruction including a selection code responsive to the TAP instruction register bit length information, the selection code configured to cause a TAP switch to select one of the TAPs;
**characterised in that**
the TAP switch is configured to maintain an idle state for a sufficient number of test clock cycles after the selection code included in the serialized instruction is received by the TAP switch, to ensure that the selected TAP will be placed in the idle state.

14. The computer program product of claim 13, further comprising program code for including the selection code in subsequently generated instruction register-related instructions.

15. The computer program product of claim 13, further comprising program code for recognizing a select TAP instruction.

## Patentansprüche

1. Ein Testzugangsport-, TAP, -Schalter zum Bereitstellen des Zugangs zu zwei oder mehr TAPs, wobei der TAP-Schalter aufweist:
eine erste Schaltung (40), konfiguriert zum Bereitstellen eines Taktsignals für einen ausgewählten TAP der TAPs, in Antwort auf einen Auswahlcode, der in einer serialisierten vom TAP-Schalter empfangenen Instruktion enthalten ist;
eine zweite Schaltung (38), aufweisend ein Instruktionsregister (IR), konfiguriert zum Weitergeben von serialisierten vom TAP-Schalter empfangenen Instruktionen zum ausgewählten TAP; und
eine dritte Schaltung (42), konfiguriert zum Weiterleiten von serialisierten vom ausgewählten TAP empfangenen Daten zu einer Ausgabe des TAP-Schalters, in Antwort auf den Auswahlcode;
**dadurch gekennzeichnet, dass**
der TAP-Schalter konfiguriert ist zum Aufrechthalten eines Leerlaufzustands für eine ausreichende Anzahl von Testtaktzyklen, nachdem der in der serialisierten Instruktion enthaltene Auswahlcode vom TAP-Schalter empfangen wird, um sicherzustellen, dass der ausgewählte TAP in den Leerlaufzustand versetzt werden wird.

2. Der TAP-Schalter nach Anspruch 1, wobei das IR konfiguriert ist zum Erfassen des Auswahlcodes in Antwort auf eine TAP-Auswahl-Instruktion.

3. Der TAP-Schalter nach Anspruch 2, wobei die zweite Schaltung (38) ferner eine Verriegelungsschaltung (52) aufweist, die konfiguriert ist zum Speichern des vom IR erfassten Auswahlcodes und zum Bereitstellen des Auswahlcodes zur ersten und dritten Schaltung.

4. Der TAP-Schalter nach Anspruch 1, wobei die zweite Schaltung (38) ferner ein Nullbit-Datenregister DR (46) aufweist, konfiguriert zum Weitergeben von serialisierten vom TAP-Schalter empfangenen Daten zum ausgewählten TAP, in Antwort auf eine Daten-Scan-Instruktion.

5. Der TAP-Schalter nach Anspruch 4, wobei die zweite Schaltung (38) ferner einen Überbrückungs-DR (48) aufweist, konfiguriert zum Umlenken der serialisierten vom TAP-Schalter empfangenen Daten zu der Ausgabe des TAP-Schalters, in Antwort auf eine Überbrückungs-Instruktion.

6. Der TAP-Schalter nach Anspruch 5, wobei die Überbrückungs-Instruktion dem Auswahlcode entspricht, der einen TAP-Schalter-Überbrückungszustand anzeigt.

7. Ein elektronisches System (10), aufweisend:
eine Vielzahl von elektronischen Schaltungskomponenten (14-18), wobei jede elektronische Schaltungskomponente einen Testzugangsport (20-24) hat; und
einen TAP-Schalter (12) nach den Ansprüchen 1 bis 4 zum Bereitstellen des Zugangs zu jedem TAP.

8. Das elektronische System nach Anspruch 7, wobei jede elektronische Schaltungskomponente (14-18) einen Kern aufweist, der mit einer System-auf-einem-Chip integrierten Schaltung assoziiert ist.

9. Das elektronische System nach Anspruch 7, wobei jede elektronische Schaltungskomponente (14-18) eine integrierte Schaltung aufweist, die auf einem Träger montiert ist.

10. Ein Verfahren zum Zugreifen auf eine von zwei oder mehreren Testzugangsports TAPs in einem elektronischen System, aufweisend:
Auswählen (100) eines der TAPs in Antwort auf einen Auswahlcode, der in einer serialisierten Instruktion enthalten ist, die von einem TAP-Schalter empfangen wird;
Weitergeben (102; 302) von serialisierter vom TAP-Schalter empfangener Information zu dem ausgewählten TAP; und
Weiterleiten (104; 304) von serialisierten vom ausgewählten TAP empfangenen Daten zu einer Ausgabe des TAP-Schalters;
**dadurch gekennzeichnet, dass**
der TAP-Schalter konfiguriert ist zum Aufrechthalten eines Leerlaufzustands für eine ausreichende Anzahl von Testtaktzyklen, nachdem der in der serialisierten Instruktion enthaltene Auswahlcode vom TAP-Schalter empfangen wird, um sicherzustellen, dass der ausgewählte TAP in den Leerlaufzustand versetzt werden wird.

11. Das Verfahren nach Anspruch 10, wobei das Auswählen (100) eines der TAPs das Bereitstellen eines aktiven Taktsignals für einen ausgewählten TAP der TAPs aufweist, in Antwort auf den Auswahlcode.

12. Das Verfahren nach Anspruch 11, wobei das Bereitstellen eines aktiven Taktsignals für einen ausgewählten TAP der TAPs aufweist:
Erfassen des Auswahlcodes im TAP-Schalter; und
Aktivieren einer Taktsignalausgabe des TAP-Schalters, der mit dem TAP korrespondiert, der mit dem erfassten Auswahlcode assoziiert ist.

13. Ein Computerprogrammprodukt zur Zugangskontrolle zu zwei oder mehr Testzugangsports (TAPs) in einem elektronischen System, aufweisend:
Programmcode zum Verarbeiten von TAP-Instruktionsregisterbitlängeninformation; und
Programmcode zum Erzeugen einer serialisierten Instruktion, die einen Auswahlcode enthält in Antwort auf die TAP-Instruktionsregisterbitlängeninformation, wobei der Auswahlcode konfiguriert ist, um einen TAP-Schalter zu veranlassen einen der TAPs auszuwählen;
**dadurch gekennzeichnet, dass**
der TAP-Schalter konfiguriert ist zum Aufrechthalten eines Leerlaufzustands für eine ausreichende Anzahl von Testtaktzyklen, nachdem der in der serialisierten Instruktion enthaltene Auswahlcode vom TAP-Schalter empfangen wird, um sicherzustellen, dass der ausgewählte TAP in den Leerlaufzustand versetzt werden wird.

14. Das Computerprogrammprodukt nach Anspruch 13, ferner aufweisend Programmcode zum Einfügen des Auswahlcodes in nachfolgend erzeugte Instruktionsregister-bezogene Instruktionen.

15. Das Computerprogrammprodukt nach Anspruch 13, ferner aufweisend Programmcode zum Erkennen einer TAP-Auswahl-Instruktion.

## Revendications

1. Un commutateur de port d'accès de test, TAP, pour procurer un accès à deux TAPs ou plus, le commutateur de TAP comprenant :
un premier circuit (40) configuré pour appliquer un signal d'horloge à l'un des TAPs sélectionnés en réponse à un code de sélection inclus dans une instruction sérialisée reçue par le commutateur de TAP ;
un second circuit (38) comprenant un registre d'instruction (IR) configuré pour transférer les instructions sérialisées reçues par le commutateur de TAP au TAP sélectionné ; et
un troisième circuit (42) configuré pour envoyer des données sérialisées reçues du TAP sélectionné vers une sortie du commutateur de TAP en réponse au code de sélection ;
**caractérisé en ce que**
le commutateur de TAP est configuré pour maintenir un état inactif pendant un nombre suffisant de cycles d'horloge de test après que le code de sélection inclus dans l'instruction sérialisée ait été reçu par le commutateur de TAP, pour être sûr que le TAP sélectionné sera placé à l'état inactif.

2. Le commutateur de TAP de la revendication 1, dans lequel l'IR est configuré pour capturer le code de sélection en réponse à une instruction de sélection de TAP.

3. Le commutateur de TAP de la revendication 2, dans lequel le second circuit (38) comprend en outre un circuit de verrouillage (52) configuré pour mémoriser le code de sélection capturé par l'IR et pour appliquer le code de sélection au premier et au troisième circuit.

4. Le commutateur de TAP de la revendication 1, dans lequel le second circuit (38) comprend en outre un registre de données de bits à zéro DR (46) configuré pour transférer des données sérialisées reçues par le commutateur de TAP vers le TAP sélectionné en réponse à une instruction d'exploration de données.

5. Le commutateur de TAP de la revendication 4, dans lequel le second circuit (38) comprend en outre un DR de contournement (48) configuré pour détourner les données sérialisées reçues par le commutateur de TAP vers la sortie du commutateur de TAP en réponse à une instruction de contournement.

6. Le commutateur de TAP de la revendication 5, dans lequel l'instruction de contournement correspond au code de sélection indiquant un état de contournement du commutateur de TAP.

7. Un système électronique (10), comprenant :
une pluralité de composants de circuit électronique (14-18), chaque composant de circuit électronique possédant un TAP de port d'accès de test (20-24) ; et
un commutateur de TAP (12) selon les revendications 1 à 4 pour procurer un accès à chaque TAP.

8. Le système électronique de la revendication 7, dans lequel chaque composant de circuit électronique (14-18) comprend un noyau associé à un circuit intégré système-sur-puce.

9. Le système électronique de la revendication 7, dans lequel chaque composant de circuit électronique (14-18) comprend un circuit intégré monté sur un support.

10. Un procédé pour accéder à l'un de deux ou plus ports d'accès de test TAPs dans un système électronique, comprenant :
la sélection (100) de l'un des TAPs en réponse à un code de sélection inclus dans une instruction sérialisée reçue par un commutateur de TAP ;
le transfert (102 ; 302) de l'information sérialisée reçue par le commutateur de TAP vers le TAP sélectionné ; et
l'envoi (104 ; 304) des données sérialisées reçues du TAP sélectionné vers une sortie du commutateur de TAP ;
**caractérisé en ce que**
le commutateur de TAP est configuré pour maintenir un état inactif pendant un nombre suffisant de cycles d'horloge de test après que le code de sélection inclus dans l'instruction sérialisée ait été reçu par le commutateur de TAP, pour être sûr que le TAP sélectionné sera placé à l'état inactif.

11. Le procédé de la revendication 10, dans lequel la sélection (100) de l'un des TAPs comprend l'application d'un signal d'horloge actif à l'un des TAPs sélectionné en réponse au code de sélection.

12. Le procédé de la revendication 11, dans lequel l'application d'un signal d'horloge actif à l'un des TAPs sélectionné comprend :
la capture du code de sélection dans le commutateur de TAP ; et
l'activation d'une sortie de signal d'horloge du commutateur de TAP correspondant au TAP associé au code de sélection capturé.

13. Un programme-produit informatique pour contrôler l'accès à deux ou plus ports d'accès de test (TAPs) dans un système électronique, comprenant :
du code de programme pour traiter une information de longueur binaire de registre d'instruction de TAP ; et
du code de programme pour générer une instruction sérialisée comprenant un code de sélection en réponse à l'information de longueur binaire de registre d'instruction de TAP, le code de sélection configuré pour faire en sorte qu'un commutateur de TAP sélectionne l'un des TAPs ;
**caractérisé en ce que**
le commutateur de TAP est configuré pour maintenir un état inactif pendant un nombre suffisant de cycles d'horloge de test après que le code de sélection inclus dans l'instruction sérialisée ait été reçu par le commutateur TAP, pour être sûr que le TAP sélectionné sera placé à l'état inactif.

14. Le programme-produit informatique de la revendication 13, comprenant en outre du code de programme pour inclure le code de sélection dans des instructions ultérieurement générées en rapport avec le registre d'instruction.

15. Le programme-produit informatique de la revendication 13, comprenant en outre du code de programme pour reconnaître une instruction de sélection de TAP.
